# EUROPEAN PATENT APPLICATION

(11) **EP 4 815 699 A1**
(43) Date of publication of application: **30.09.2026**
(21) Application number: 25166707.7
(22) Date of filing: 27.03.2025
(51) Int. Cl.: H10N 50/01, H10N 50/10, H10N 50/85

(54) **SWITCHING DEVICE AND MAGNETORESISTIVE RANDOM ACCESS MEMORY DEVICE, AND PROCESS OF FORMING A SWITCHING DEVICE**

(71) Applicant: Merck Patent GmbH, 64293 Darmstadt (DE); Technische Universität München, 80333 München (DE); Technische Universität Darmstadt, 64289 Darmstadt (DE)
(72) Inventor: PFEIFFER, Christian, 80333 München (DE); TORNOW, Marc, 80333 München (DE); KIRSCH, Peer, 64289 Darmstadt (DE); NALAKATH, Abin Nas, 64289 Darmstadt (DE)
(74) Representative: Merck Patent Association

(57) **Abstract**

The present application addresses a switching device (1). The switching device (1) comprises a magnetic reference analogue portion which comprises a layer made using chiral molecules (2).

## Description

The present application addresses a switching device, a magnetoresistive random access memory device, magnetic field sensor, a device for neuromorphic computing, a device for reading a hard disc drive, a device for quantum computing, and a process of forming a switching device.

Switching devices in general and in particular magnetoresistive random access memory, in short MRAM, technology have been the subject of extensive studies in recent years. In particular, spin-transfer torque magnetic tunnel junctions have attracted attention. Devices in the field of neuromorphic computing and quantum computing have also attracted attention. Devices using a magnetic reference layer and an information-storing free layer give access to non-volatile information storage. The requirement for miniaturization has increased in this field. The simplicity of manufacturing devices and the cost-effectiveness of manufacturing and devices may also be improved.

In view of this, the present disclosure provides an alternative or improved device.

In light of the above, the inventors found that chirality-induced spin-selectivity (CISS) may be applied to provide improvements or alternative constructions. Chirality-induced spin-selectivity is founded on the studies by Ray et al. (K. Ray, S. Ananthavel, D. Waldeck and R. Naaman, "Asymmetric Scattering of Polarized Electrons by Organized Organic Films of Chiral Molecules," Science, 1999) who reported an asymmetric scattering or spin-polarized light ejected electrons transmitted through chiral molecules. Further studies regarding chirality-induced spin-selectivity were later observed for solid state charge transport by Xie et al. (Z. Xie, T. Z. Markus, S. Cohen, Z. Vager, R. Gutierrez and R. Naaman, "Spin Specific Electron Conduction through DNA Oligomers," Nano Letters, 2011). It is still debated in scientific literature whether chiral molecules act as spin filters or as spin polarizers (Y. Wolf, Y. Liu, J. Xiao, N. Park and B. Yan, "Unusual Spin Polarization in the Chirality-Induced Spin Selectivity," ACS Nano, 2022).

In previous studies a number of factors limited the applicability of the effect. In particular the materials studied in scientific studies were quite limited, for example they focused on thiolated biomolecules such as doublestranded DNA or amino-acid derivatives (B. Göhler, V. Hamelbeck, T. Z. Markus, M. Kettner, G. F. Hanne, Z. Vager, R. Naaman and H. Zacharias, "Spin Selectivity in Electron Transmission Through Self-Assembled Monolayers of DoubleStranded DNA," Science, 2011; Z. Xie, T. Z. Markus, S. Cohen, Z. Vager, R. Gutierrez and R. Naaman, "Spin Specific Electron Conduction through DNA Oligomers," Nano Letters, 2011; D. H. Waldeck, R. Naaman and Y. Paltiel, "The spin selectivity effect in chiral materials," APL Materials, 2021; T. Nguyen, L. Rasabathina, O. Hellwig, A. Sharma, G. Salvan, S. Yochelis, Y. Paltiel, L. Baczewski and C. Tegenkamp, "Cooperative Effect of Electron Spin Polarization in Chiral Molecules Studied with Non-Spin-Polarized Scanning Tunneling Microscopy," ACS Applied Materials & Interfaces, 2022; M. Kettner, B. Göhler, H. Zacharias, D. Mishra, V. Kiran, R. Naaman, C. Fontanesi, D. Waldeck, S. Sek, J. Pawlowski and J. Juhaniewicz, "Spin Filtering in Electron Transport Through Chiral Oligopeptides," The Journal of Physical Chemistry C, 2015). Also, the substrate materials explored were limited (for example C. Vericat, M. E. Vela, G. Corthey, E. Pensa, E. Cortés, M. H. Fonticelli, F. Ibañez, G. E. Benitez, P. Carro and R. C. Salvarezza, "Self-assembled monolayers of thiolates on metals: a review article on sulfur-metal chemistry and surface structures," RSC Advances, 2014; I. Carmeli, K. Senthil Kumar, O. Heifler, C. Carmeli and R. Naaman, "Spin selectivity in electron transfer in photosystem I," Angewandte Chemie International Edition, 2014; N. Goren, T. K. Das, N. Brown, S. Gilead, S. Yochelis, E. Gazit, R. Naaman and Y. Paltiel, "Metal Organic Spin Transistor," Nano Letters, 2021; T. Das, F. Tassinari, R. Naaman and J. Franssion, "Temperature-Dependent Chiral-Induced Spin Selectivity Effect: Experiments and Theory," The Journal of Physical Chemistry C, 2022; T. Nguyen, L. Rasabathina, O. Hellwig, A. Sharma, G. Salvan, S. Yochelis, Y. Paltiel, L. Baczewski and C. Tegenkamp, "Cooperative Effect of Electron Spin Polarization in Chiral Molecules Studied with Non-Spin-Polarized Scanning Tunneling Microscopy," ACS Applied Materials & Interfaces, 2022; Y. Kapon, F. Kammerbauer, S. Yochelis, M. Kläui and Y. Paltiel, "Magneto-optical imaging of magnetic-domain pinning induced by chiral molecules," The Journal of Chemical Physics, 2023). The above-listed studies explore some underlying scientific questions; however they do not attempt to provide applicable devices. Even patent literature, as in particular US20150049542A1, shows only limited practical applicability due to limitations regarding selection of chiral materials and substrates application.

Accordingly, in light of this at least some of the embodiments below provide alternatives and improvements to these additional issues.

According to a first embodiment, a switching device is described. The switching device comprises a magnetic reference analogue portion. The magnetic reference analogue portion is a portion of the device which may have a functionality analogue to a magnetic reference layer, which, for example, may be found in a spin-transfer torque magnetic tunnel junction.

In particular, the inventors of the present invention found that a layer made using chiral molecules can help to improve the functionality of a magnetic reference layer or a similar layer or replace such a layer and thereby help to decrease the size and/or thickness of a device.

The layer made using chiral molecules may alternatively be called a "chiral layer". The layer made using chiral molecules can be any layer that is made, including chiral molecules, in its making. A layer made using chiral molecules can be a layer that comprises chiral molecules or has received some properties from chiral molecules. According to an embodiment, the layer made using chiral molecules may comprise or consist of chiral molecules, for which the layer may be called a "chiral molecular layer". Alternatively, according to an embodiment the layer made using chiral molecules can be a chirally imprinted layer. The latter does not necessarily comprise chiral molecules, however chiral features of these molecules are directly or indirectly imprinted into the material of the chirally imprinted layer.

Also, according to a further embodiment, the layer made using chiral molecules may comprise or consist of a chiral organic-inorganic material. This material can be deposited by atomic layer deposition, for example. For example, sufficiently volatile chiral organic co-components can be used in chiral atomic layer deposition processes. As an example, chiral Al₂O₃ can be formed using an atomic layer deposition process including D- or L-alaninol as the chiral component.

According to a further embodiment of the switching device, the magnetic reference analogue portion may comprise a magnetic reference layer. This magnetic reference layer can be a common magnetic reference layer as is found in a common spin transfer torque magnetic tunnel junction. This magnetic reference layer has pinned magnetic orientation. Furthermore, in this embodiment, the magnetic reference analogue portion may also comprise a layer made using chiral molecules. The layer made using chiral molecules can neighbor the magnetic reference layer.

The inventors found that if a layer made using chiral molecules is introduced into a classical magnetic tunnel junction, the magnetoresistance ratio of the two states of the magnetic tunnel junction can be increased. Of course, also in this case, the layer made using chiral molecules can be a chiral molecular layer or it can be a chirally imprinted layer.

According to an embodiment, the entire reference analogue portion can be a layer made using chiral molecules. The inventors found that a layer made using chiral molecules can functionally replace a magnetic reference layer with pinned magnetic orientation in a magnetic tunnel junction. Of course, also in this case, the layer made using chiral molecules can be a chiral molecular layer or it can be a chirally imprinted layer.

The inventors found that if the entire reference analogue portion is a layer made using chiral molecules this helps to simplify manufacturing of the device and may also help to reduce the thickness.

According to an embodiment, the chiral molecular layer may have enantiomeric excess such that it has net chirality.

According to an embodiment, the chirally imprinted layer may be made using an enantiomeric excess such that the net chirality of the enantiomeric excess is imprinted into the chirally imprinted layer.

According to an embodiment, the chiral molecular layer may comprise or consist of chiral molecular units. A chiral molecular unit comprising or consisting of chiral molecular compounds may be easily deposited or integrated into a switching device and helps to reduce its size.

According to an embodiment, these chiral molecular units can have an anchor group. The anchor group of the free molecule is capable of chemically attaching the molecular unit to a surface. Preferably, this unit is capable of attaching the molecule to surfaces of materials present in magnetic tunnel junctions. The anchor groups can provide any type of chemical interaction capable of anchoring a molecule. These may include covalent bonds, dipole-dipole interactions, hydrogen bonds or Van der Waals interactions. Preferably, the anchor group provides covalent anchoring. For example, anchor groups can be selected from phosphonic acids, phosphoric acids, phosphinic acids or carboxylic acids. Anchor groups have been shown to facilitate easy deposition and attachment of the molecules via technically simple deposition techniques.

Furthermore, according to a further embodiment, the chiral molecular layer can be a monolayer or a sub-monolayer. The inventors found that the above technical effects can already be achieved with monolayer coverage or even below this. This makes it possible to have small layer thicknesses. Layer thicknesses may, for example, be 5 nm or below, such as 1 nm or below.

In particular, according to an embodiment, the chiral molecular layer can be a self-assembled monolayer. A self-assembled monolayer can be a monolayer that saturates a surface with anchored molecules. For example, but not limiting, the self-assembled monolayer, for example using the above-mentioned anchor group, can be formed by dip-coating, spin-coating, thermal evaporation molecular epitaxy.

Also, according to an embodiment, a dielectric layer can be arranged on top of a self-assembled monolayer. This may help to further stabilize the self-assembled monolayer. For example, the stabilizing dielectric layer may be deposited via atomic layer deposition or sputtering. The thickness of such a layer can be in the range of 1 to 5 nm. For example, materials used for such a dielectric layer can be magnesium oxide, aluminum oxide, silicon oxide, hafnium oxide. Also, tantalum oxides (TaOₓ) may be used.

According to an embodiment, the chiral molecular layer can comprise a chiral molecular compound. The chiral molecular compound may have a chiral group. The chiral group, for example, can have a propellor or screw-like structure. For example, it may have local C2 symmetry. Examples for a chiral molecular compound can be a 1,1'-binaphth-2,2'-diol derivative, such as 1,1'-binaphthyl-2,2'-diyl hydrogenphosphate. Such chiral molecular compounds can be easily introduced into a switching device and provide the above-mentioned advantages.

According to an embodiment, the chiral molecular layer can comprise a chiral macromolecule, such as a chiral polymer. Examples of a chiral polymer can be cellulose, chitosan, polylactide or similar. In particular in the case of polymers, spin-coating deposition or other deposition techniques may be used. For example, a layer thickness of 1 to 5 nm can be used.

Also, according to an embodiment, the switching device (1) may further comprise an insulating tunnel barrier and an information-storing free layer. The magnetic reference analogue portion, the insulating tunnel barrier and an information-storing free layer may be arranged in a stack. In this case the insulating tunnel barrier is arranged above a first side of the information-storing free layer. Furthermore, the insulating tunnel barrier is arranged between the magnetic reference analogue portion and the information-storing free layer. The described layers or portions of this stack may be in direct contact with each other. Alternatively, additional layers may be arranged between the magnetic reference analogue portion, the insulating tunnel barrier and an information-storing free layer. Such additional layers may be Ta-layers or other similar layers, for example.

According to an embodiment that may be based on the previous embodiment, the switching device may comprise a further insulating tunnel barrier and a further magnetic reference analogue portion. These may be arranged above a second side of the information-storing free layer. The further insulating tunnel barrier in this case is arranged between the information-storing free layer and the further magnetic reference analogue portion. The inventors found that by this, a four-terminal device can be formed.

Regarding the previous embodiment, in other words, a four-terminal device having two magnetic reference analogue portions above two sides of the information-storing free layer is provided. Each of these may have a layer made using chiral molecules. In this case, two sub-cases or two sub-embodiments may be formed. According to a first case both layers made using chiral molecules may have the same chirality, for example by being layers of molecules of the same handedness. According to a second case, both layers made using chiral molecules may have opposite chirality, for example by being layers of molecules of the opposite handedness. In both cases three memory states can be formed. Alternatively, the device may also be configured to be operable as two-terminal device.

Also, according to an embodiment, the switching device may comprise means for applying a voltage and/or a current to the stack. These means may include contacts and/or circuitry and/or power sources and/or means for measuring currents or voltages.

According to an embodiment the information-storing free layer comprises or consists of a material exhibiting perpendicular magnetic anisotropy. For example, the information-storing free layer comprises or consists of a ferromagnetic material, such as an Fe-based material, and FeCo-based material, a Dy-containing material, a Ho-containing materiel, CoFeB-based material, a Co-based material. Alternatively the information-storing free layer may have insertion layers, such as insertion layers comprising or consisting of Mo. According to another embodiment the material of the information-storing free layer comprises or consists a Ni-based material. For example, it may comprise or consist metallic Ni. In this embodiment, the Ni-based information-storing free layer may exhibit perpendicular magnetic anisotropy, but is not limited to that. Some Ni-based information-storing free layers may not exhibit perpendicular magnetic anisotropy.

According to embodiments, the above-described switching devices or the arrangements discussed above can be used, incorporated into or be part of a magnetoresistive random access memory device, a device for neuromorphic computing, a device for reading a hard disc drive, or a device for quantum computing.

Furthermore, a process of forming a switching device is described. The embodiments, features or advantages described with respect to the switching device may also apply to the process and vice versa.

According to an embodiment the process comprises a step of forming an information-storing free layer. Furthermore, it comprises the step of forming a layer made using chiral molecules above the information-storing free layer.

According to an embodiment, the layer made using chiral molecules may be formed via immersion in solution, Langmuir-Blodgett technique, molecular layer deposition, spin coating, or a sol-gel process.

Further embodiments or features may become apparent from the following exemplary embodiments described in connection with the figures. However, the invention is not limited to said exemplary embodiments. Furthermore, said exemplary embodiments are at least partially depicted in figures showing schematic drawings. Such schematic drawings are not true to scale and absolute and relative dimensions can be depicted in a distorted manner. Rather, individual elements may be shown exaggeratedly large for better representability or better understandability. Accordingly, no absolute or relative dimensions can be taken from the schematic depictions unless otherwise indicated. Elements that are identical, similar or have the same effect or are configured to provide a similar effect are denoted by the same reference signs in the figures.
Figure 1 shows a first exemplary embodiment of a switching device.
Figure 2 shows a second exemplary embodiment of a switching device.
Figure 3 shows a third exemplary embodiment of a switching device.
Figure 4 shows a fourth exemplary embodiment of a switching device.
Figure 5 shows enantiomers of 1,1'-binaphthyl-2,2'-diyl hydrogenphosphate.
Figure 6 shows results of a laser-based polar magneto-optic Kerr effect measurement.
Figure 7 shows results of EGaIn-based spin polarization measurements.

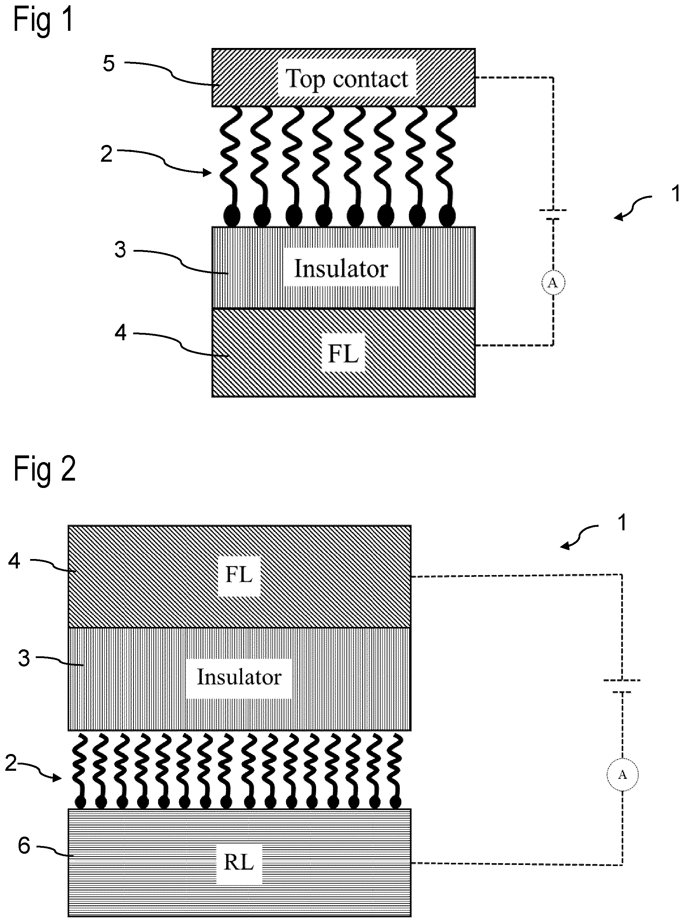

We propose a novel spin-transfer torque magnetic switching device which utilizes the CISS effect outlined above to achieve two different magnetoresistance states. The structure of this device is depicted in Figure 1.

In Figure 1 a first exemplary embodiment of a switching device 1 is shown in a schematic cross-section-like representation. The present exemplary embodiment utilizes the CISS effect and represents the relevant features of a device that can serve the same or a similar function as a spin-transfer torque magnetic switching (STT-MTJ) device.

The switching device 1 shown in Figure 1 has a stack of layers. It comprises an information-storing free layer 4, which also may be abbreviated as FL. The information-storing free layer 4 can comprise or consist of any material exhibiting a perpendicular magnetic anisotropy (PMA). The information-storing free layer 4 may be a common information-storing free layer used in common magnetoresistive random access memory spin-transfer torque devices. Alternatively, the information-storing free layer 4 may comprise or consist of CoFeB, Co, Fe, FeCo, Dy, Ho. Also, it may be any optimized material combination with insertion layers such as (but not limited to) Mo. Also, alternatively, the information-storing free layer 4 can comprise or consist of Ni. In this case it may or may not exhibit perpendicular magnetic anisotropy.

For example, the information-storing free layer 4 including such materials may also have additional layers that are not explicitly depicted in the Figure.

For example, a material combination based on CoFeB, such as for example CoFeB/MgO, CoFeB/Ta, CoFeB/Pt, CoFeB/W, or CoFeB/Cr can be used. Also, a material combination based on Co, such as for example Co/MgO, Co/Pt, Co/Ru, or Co/Ir can be used. Also, the other materials mentioned above can be included in similar material combinations.

For example, materials or techniques as described in the following publications may be used to form the information-storing free layer 4:
M. Akyol, "Origin of Interfacial Magnetic Anisotropy in Ta/CoFeB/MgO and Pt/CoFeB/MgO Multilayer Thin Film Stacks," Journal of Superconductivity and Novel Magnetism, 2019*.*
S. Chiba, Y. Marui, H. Ohno and S. Fukami, "Comparative Study of Current-Induced Torque in Cr/CoFeB/MgO and W/CoFeB/MgO," Nano Letters, 2024.
H. X. Yang, M. Chshiev, B. Dieny, J. H. Lee, A. Manchon and K.H. Shin, "First-principles investigation of the very large perpendicular magnetic anisotropy at Fe|MgO," Physical Review B*.*
T. Nozaki, M. Konoto, T. Nozaki, H. Kubota, A. Fukushima and S. Yuasa, "Control of the magnetic domain of Pt/Co/Ru/MgO multilayer: Effect of Co thickness and Ru insertion," AIP Advances, 2020*.*
K. Shahbazi, J.-V. Kim, H. T. Nembach, J. M. Shaw, A. Bischof, M. D. Rossell, V. Jeudy, T. A. Moore and C. H. Marrows, "Domain-wall motion and interfacial Dzyaloshinskii-Moriya interactions in Pt/Co/Ir(tIr)/Ta multilayers," Physical Review B, 2019.
S. Nazir, S. Jiang, J. Cheng and K. Yang, "Enhanced interfacial perpendicular magnetic anisotropy in Fe/MgO heterostructure via interfacial engineering," Applied Physics Letters, 2019.
Z. Zhu, Y. Wan, H. Long, X. Wang, X. Wang, L. Lang, L. Ma and F. Zheng, "High thermal stability of perpendicular magnetic anisotropy in MgO/CoFeB/W structures by a Mo insertion layer," Surfaces and Interfaces, 2025.

An isolating tunneling barrier 3 (also labeled "Insulator" in the Figure) is arranged above the information-storing free layer 4. The material of the isolating tunneling barrier 3 is not limited, as long as it provides an insulating function and a barrier function. For example, the isolating tunneling barrier 3 may comprise or consist of MgO. Alternatively or additionally, a native oxide on a metal layer such as a Ta-layer with Ta-surface oxide may be part of the isolating tunneling barrier 3.

A layer made using chiral molecules 2 is arranged above the isolating tunneling barrier 3. The layer made using chiral molecules 2 may alternatively be called a "chiral layer". In the present case the layer made using chiral molecules 2 is represented by a schematic sketch of a self-assembled monolayer of chiral molecules.

A first contact 5 is arranged above the layer made using chiral molecules 2. This first contact 5 can also be called a "top contact", as indicated in Figure 1. Together with the schematic partial circuit indicated in the figure by the dashed line, the first contact 5 and the information-storing free layer 4 represent means for applying a voltage and/or a current to the stack. Here the partial circuit indicated in the figure by the dashed line represents means for application of voltage and simultaneous measurement of current. Other means can also be used. The first contact 5 can be metallic.

In the present embodiment, the layer made using chiral molecules 2 functionally replaces a magnetic reference layer of a common spin-transfer torque magnetic tunnel junction. Accordingly, in the present example the layer made using chiral molecules 2 is a magnetic reference analogue portion.

A common magnetic reference layer needs a pinned magnetization throughout the operation of the MRAM. A common approach to achieve this is a synthetic antiferromagnet structure (SAF). Such a synthetic antiferromagnet structure typically consists of multiple layers including two additional ferromagnetic layers and an antiferromagnetic thin film (e.g. Ir-Mn), the fabrication of which often requires laborious technology/processing. Moreover, a typical magnetic reference layer stack is quite thick, often in the range of 10 to 15 nm.

The inventors found that the layer made using chiral molecules 2 in the form of a chiral self-assembled monolayer reaches sufficient spin polarization (due to the CISS effect) to switch the magnetization of the information-storing free layer 4. In this system, the layer made using chiral molecules 2 seems to function as a spin filter independent of the current direction and consequently serves the same purpose as a common reference layer in a common STT-MTJ. Based on the spin-transfer torque (STT), the spin-polarized current generated by the layer made using chiral molecules 2 transfers the spin angular momentum to the information-storing free layer 4, resulting in a switched magnetization. This function is supported or enabled by the information-storing free layer 4 comprising or consisting of a ferromagnetic material exhibiting PMA.

If a voltage is applied as indicated by the schematic circuit in Figure 1, the resulting current depends on the magnetization of the information-storing free layer 4 and the preferred spin of the chiral material of the layer made using chiral molecules 2. In the case that the magnetization of the information-storing free layer 4 is parallel to the preferred spin of the layer made using chiral molecules 2, the tunnel junction exhibits a low overall resistance ("quasi-magnetoresistance"). In contrast, if the magnetization of the information-storing free layer 4 is antiparallel to the preferred spin of the layer made using chiral molecules 2, the device will exhibit a high resistance state.

Any material that provides net-chirality may be used as material for the layer made using chiral molecules 2. For example, a chiral molecular layer may be used. Such a chiral molecular layer may comprise or consist of chiral molecules. It may have an enantiomeric excess of one or several enantiomers of enantiomer pairs.

As depicted in Figure 1, the layer made using chiral molecules 2 can be a self-assembled monolayer of one or several chiral molecular compounds. These compounds preferably have an anchor group that chemically anchors these molecules to the surface of, or a surface above, the isolating tunneling barrier 3. The anchor group is not limited and can provide any type of anchoring including covalent bonding, dipole-dipole-interactions, hydrogen bonding or van der Waals bonding. Preferably the chiral molecular compound is covalently anchored. Most preferably, the anchor group is a phosphonic acid, phosphoric acid, phosphinic acid, or carboxylic acid. The chiral group can possess any type of chirality, such as a propeller- or screw-like substructure with local C₂-symmetry. Examples of such a chiral molecular compound are a 1,1'-binaphth-2,2'-diol derivatives, such as 1,1'-binaphthyl-2,2'-diyl hydrogenphosphate. In particular these self-assembled monolayers are thin and easy to fabricate.

Such self-assembled monolayers can be formed by dip-coating or spin-coating, or, depending on the molecular weight, by thermal evaporation or molecular epitaxy, followed by a thermal annealing step. These processes are simple to implement and provide self-limiting reactions, by which the desired surfaces are covered with a monolayer of one or more chiral molecular compounds.

Furthermore optionally, the chiral self-assembled monolayer may be additionally stabilized by arranging a dielectric layer on top of it (not depicted in Figure 1). This additional dielectric layer can be formed by atomic layer deposition (ALD) or sputtering. It may have a thickness of 1 to 5 nm. For example, the dielectric layer may comprise or consist of MgO, Al₂O₃, SiO₂, HfO₂, or TaOₓ.

Alternatively or additionally, the layer made using chiral molecules 2 could comprise or consist of chiral macromolecules. It may comprise or consist of one or more chiral polymer. Examples of chiral polymers can be cellulose, chitosane, polylactide or their derivatives. The polymer can be deposited by spin-coating from a solution. A layer thickness can be 1 to 5 nm. In this case a thin and/or easily fabricated layer can substitute a common magnetic reference layer of a common device.

Alternatively, the layer made using chiral molecules 2 could comprise or consist of a chirally imprinted inorganic material, such as a chirally imprinted inorganic dielectric or a chirally imprinted metal. Examples for a chirally imprinted inorganic dielectric are Al₂O₃, SiO₂ or HfO₂. The means for forming a chirally imprinted layer are not limited. For example, dielectric-imprinting may be achieved by a sol-gel process in a chiral solvent, such as for example propylene glycol and/or in the presence of chiral additives, such as tartaric acid, lactic acid. A method as described in M. Sharon and D. Avnir, "The Induction of Chirality in Sol-Gel Materials," Accounts of Chemical Research, 2007 may be used. An alternative way to obtain a chirally imprinted material and in particular a chirally imprinted oxide is atomic layer deposition including a chiral templating reagent, such as R- or S-leucinol. For example, a method as described in H. Al-Bustami, S. Khaldi, O. Shoseyov, S. Yochelis, K. Killi, I. Berg, E. Gross, Y. Paltiel and R. Yerushalmi, "Atomic and Molecular Layer Deposition of Chiral Thin Films Showing up to 99% Spin Selective Transport," Nano Letters, 2022 may be used.

Alternatively, also the layer made using chiral molecules 2 may comprise or consist of a chiral organic-inorganic material. This material can be deposited by atomic layer deposition, for example. As an example chiral Al₂O₃ can be formed using an atomic layer deposition process including D-or L-alaninol as the chiral component. The technique described in H. Al-Bustami, S. Khaldi, O. Shoseyov, S. Yochelis, K. Killi, I. Berg, E. Gross, Y. Paltiel, R. Yerushalmi, "Atomic and Molecular Layer Deposition of Chiral Thin Films Showing up to 99% Spin Selective Transport", Nano Lett. 2022, 22, 5022-5028 may be used. Form this approach the inventors conclude that sufficiently volatile chiral organic co-components can be used in chiral atomic layer deposition processes.

The inventors found that the above-described advantages can be achieved by using this approach. Also, this approach is advantageous as the inventors found that the spin selectivity effect of the layer made using chiral molecules 2 can be sufficient to result in two distinct resistance states, such that the "information" of the information-storing free layer 4 can be read with a low error rate.

Also, the above-described materials of the layer made using chiral molecules 2 show good complementarity with the materials of the stack, but also generally with materials that are used in spintronic applications, such as CoFeB, Ta or MgO.

Furthermore, the proposed materials for the layer made using chiral molecules 2 can have sufficient conductivity to reach the critical current that allows for the magnetization of the information-storing free layer 4 to be switched. For example, the layer made using chiral molecules 2 can have or can be set to exhibit the necessary critical current density. The necessary critical current density depends on the material choice and device geometry. For example for a Nb/CoFeB/MgO heterostructure with PMA a quasi-static switching current density of 7.3·10⁵ A·cm⁻² was observed (see B. Zhou, P. Khanal, O. Benally, D. Lyu, D. Gopman, A. Enriquez, A. Habiboglu, K. Warrilow, J.-P. Wang and W.-G. Wang, "Perpendicular magnetic anisotropy, tunneling magnetoresistance and spin-transfer torque effect in magnetic tunnel junctions with Nb layers," Sci Rep, 2023.) From this the inventors conclude that in many cases the layer made using chiral molecules 2 may allow at least for a current density of 7.3·10⁵ A·cm⁻².

The first exemplary embodiments can be fabricated including the following methods or steps:
- Forming a bottom electrode (not depicted) together with a soft magnetic layer for the information-storing free layer 4. For deposition of the magnetic layers for example sputtering, chemical vapor deposition, molecular beam epitaxy, atomic layer deposition, thermal evaporation or electron beam evaporation can be used. The structuring of the bottom electrode or the magnetic material can be realized with, among others, standard lithography processes followed by lift-off and/or any form of etching and/or selective deposition with a shadow mask. Etching, for example, can be wet etching or reactive ion etching.
- The layer made using chiral molecules 2 can formed as a self-assembled monolayer as described above and/or by immersion in solution, Langmuir-Blodgett technique, molecular layer deposition, spin-coating or a sol-gel process.
- Deposition of a first contact 1 on top of the chiral layer. The deposition and structuring of that electrode can, in principle, be achieved with the same methods as described for the bottom electrode and/or the soft magnetic layer. Preferred materials for this can be Ti/Au or Pb/Ag, without being exclusively confined thereto. The process can be performed as described in P. Kirsch, J. M. Dlugosch, T. Kamiyama et al., "Restricting Conformational Space: A New Blueprint for Electrically Switchable Self-Assembled Monolayers," Small, 2024 or in J. M. Dlugosch, H. Seim, A. Bora, T. Kamiyama, I. Lieberman et al., "Conductance Switching in Liquid Crystal-Inspired Self-Assembled Monolayer Junctions," ACS Applied Materials & Interfaces, for example.

In Figure 2 a second exemplary embodiment of a switching device 1 is shown in a schematic cross-section-like representation. Also, this exemplary embodiment may particularly represent the relevant features of a spin-transfer torque magnetic switching (STT-MTJ) device which utilizes the CISS effect.

As can be seen in Figure 2, several layers that are found in Figure 1 (first exemplary embodiment) are also present in Figure 2. The materials and functionality as well as the principle design-options that were described for these are identical to the ones described for the first exemplary embodiment, if not indicated differently in the following.

In the second exemplary embodiment a magnetic reference layer 6 is realized which is also labeled RL in Figure 2. A layer made using chiral molecules 2 is arranged on or above the magnetic reference layer 6. In the depiction of Figure 2 the layer made using chiral molecules 2 is again represented as a schematically sketched chiral self-assembled monolayer. Regarding the chiral self-assembled monolayer, the features described with respect to the first exemplary embodiment apply. Alternatively, it is indicated that the layer made using chiral molecules 2 can comprise or consist of chiral macromolecules, such as chiral polymers or a chirally imprinted layer, as described above with respect to the first exemplary embodiment.

In the present embodiment it is depicted that the chiral self-assembled monolayer is anchored to the magnetic reference layer 6. However, it may also be anchored to the isolating tunneling barrier 3. The above described may apply also here for the isolating tunneling barrier 3.

In the present embodiment the magnetic reference layer 6 can be any common magnetic reference layer. In particular, it is a magnetically pinned layer. Accordingly, the layer made using chiral molecules 2 could be incorporated into an otherwise common STT-MTJ device, as is illustrated in Figure 2. By placing the layer made using chiral molecules 2 between the magnetic reference layer 6 and the isolating tunneling barrier 3, the level of spin polarization of the current entering the information-storing free layer 4 can be increased. This may lead to a more pronounced change of magnetoresistance when the magnetization of the information-storing free layer 4 is changed. As shown, the combined layer of the layer made using chiral molecules 2 and the magnetic reference layer 6 functionally acts like a common magnetic reference layer but has improved properties. Accordingly, the combined layer of the layer made using chiral molecules 2 and the magnetic reference layer 6 can be called a "magnetic reference analogue portion".

The above-said may apply for the information-storing free layer 4. Also, it is noted that the stacking order of the layers in the second exemplary embodiment here in Figure 2 is inverted with respect to the depiction of the first exemplary embodiment in Figure 1. This, of course, has no technical effect.

The embodiments of Figures 1 and 2 may be used in spintronic applications such as reading hard disc drives, MRAM technologies or in the field of neuromorphic computing.

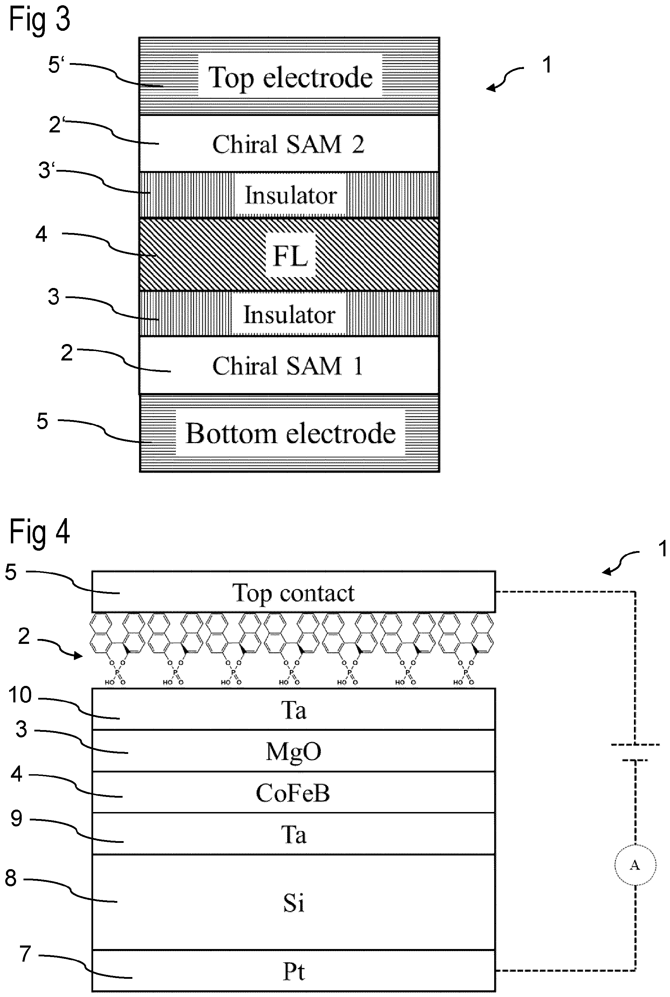

In Figure 3 a third exemplary embodiment of a switching device 1 is shown in a schematic cross-section-like representation. This third exemplary embodiment represents a four-terminal device, which is capable of generating three memory states.

Generally, the stack consisting of the first contact 5, the layer made using chiral molecules 2, the isolating tunneling barrier 3 and the information-storing free layer 4 can be the same as described for the first exemplary embodiment with respect to Figure 1. However, the formal order of the layers is inversed here.

Additionally, on the other side of the information-storing free layer 4 a second isolating tunneling barrier 3', a second layer made using chiral molecules 2' and a second contact 5' are arranged. These layers may each have the properties of the first contact 5, the layer made using chiral molecules 2 and the isolating tunneling barrier 3 which was described for the first exemplary embodiment with respect to Figure 1.

Accordingly, the third exemplary embodiment has two layers made using chiral molecules, i.e. the layer made using chiral molecules 2 and the second layer made using chiral molecules 2'. For both layers the features described with respect to the layer made using chiral molecules 2 of the first exemplary embodiment may apply. For example, as indicated by the terms chiral SAM 1 and chiral SAM 2 the layers can be self-assembled monolayers, as described above. Alternatively, instead of the layer made using chiral molecules 2 and/or the second layer made using chiral molecules 2', the magnetic reference analogue portion described with respect to the second exemplary embodiment can be used. The layer made using chiral molecules 2 and the second layer made using chiral molecules 2' can be identical or different.

The third exemplary embodiment can be realized in two ways, each representing an individual embodiment:
a) the layer made using chiral molecules 2 and the second layer made using chiral molecules 2' are of the same handedness; or
b) the layer made using chiral molecules 2 and the second layer made using chiral molecules 2' are of the opposite handedness.

In option a), if the layers made using chiral molecules act as a spin filter, one of the layers made using chiral molecules (e.g. the layer made using chiral molecules 2) produces a spin-polarized current (if a voltage is applied over the layer made using chiral molecules 2) to switch the magnetization of the information-storing free layer 4, essentially writing a first memory state. To change this state, a second voltage (applied over the second layer made using chiral molecules 2') is applied with the same voltage polarity. If the number of charges transferred is equal, the information-storing free layer 4 will reach a demagnetized state (a second memory state). To reach a third memory state, the current continues to be driven, which flips the magnetization direction.

In the case of option b), the current of one of the layers made using chiral molecules (e.g. the layer made using chiral molecules 2) again produces the spin-polarized current (if a voltage is applied over the layer made using chiral molecules 2) to switch the magnetization of the information-storing free layer 4. To change this state, the second voltage (applied over the second layer made using chiral molecules 2') is applied with the opposite voltage polarity (due to the opposite handedness of the layers made using chiral molecules). Analogously, this can demagnetize the information-storing free layer 4 and - if the current is applied for a longer period of time - also flip the information-storing free layer 4 in the opposite direction.

In the present exemplary embodiment, the layers made using chiral molecules at least effectively seem to work as spin polarizers. In this case, the device can be operated as a two-terminal device if the two layers made using chiral molecules are of the same chirality (option a)). If the current direction is from the bottom electrode to the top electrode, the layer made using chiral molecules 2 will flip the information-storing free layer 4 in one direction, while second layer made using chiral molecules 2' will have no effect as it is spin-polarizing. Reversing the current direction, the second layer made using chiral molecules 2' will now produce the opposite spin to the layer made using chiral molecules 2. Therefore, the information-storing free layer 4 can be switched in the opposite direction. This time the layer made using chiral molecules 2 will have no effect on the information-storing free layer 4.

With respect to Figures 4 to 7, a fourth exemplary embodiment is described as well as measurements that are related to this specific embodiment.

In Figure 4 the fourth exemplary embodiment of a switching device 1 is shown in a schematic cross-section-like representation. The fourth exemplary embodiment is a switching device 1 that is functionally based on and is a possible implementation of the first exemplary embodiment.

The switching device 1 according to the fourth exemplary embodiment has a portion (stack) that was formed first. A bottom contact 7 consists of a thin Pt-layer that is sputtered onto the backside of a highly doped p-Si substrate 8. The bottom contact 7 and the substrate 8 were used in obtaining the subsequently presented measurement results, however they are not necessary for the main functionality of the device. A first Ta-layer 9 consisting of tantalum and having a thickness of 2.5 nm is arranged on the other side of the substrate 8. On the first Ta-layer 9 the information-storing free layer 4 is arranged, which in the present case consists of Co₂₀Fe₆₀B₂₀. It has a thickness of 0.9 nm. Please note that the combined structure of the Ta-layer 9 and the information-storing free layer 4 can be an example of a material combination discussed for the first exemplary embodiment. The isolating tunneling barrier 3 is arranged on the information-storing free layer 4. It consists of MgO and has a thickness of 1.0 nm. A second Ta-layer 10 consisting of tantalum and having a thickness of 1.3 nm is arranged on the isolating tunneling barrier 3. The Ta/Co₂₀Fe₆₀B₂₀/MgO/Ta combination provides both the PMA of the information-storing free layer 4 and a barrier function of the isolating tunneling barrier 3.

The above layers were fabricated with radio frequency sputtering in argon. Afterwards, the stack formed so far was annealed in N₂ at 275 °C for 5 min. Further details on how the above-described stack can be fabricated may be taken from US10658574B2 or US9224942B2.

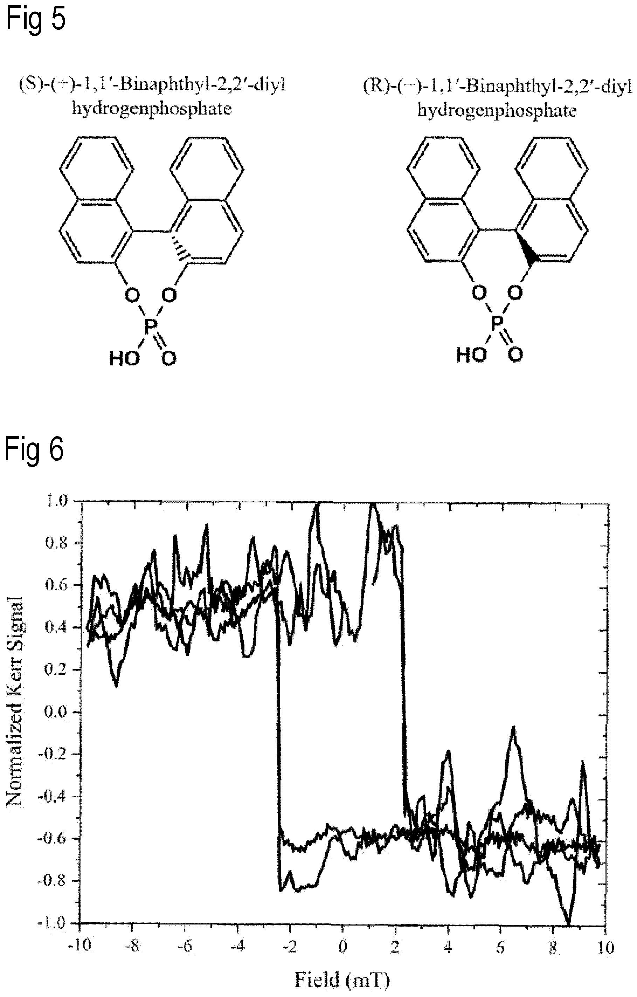

The stack fabricated so far was analyzed via polar magneto-optic Kerr effect measurements regarding magnetic behavior. The respective results are depicted in Figure 6. As can be seen, the layer stack exhibits the desired magnetic behavior and a clear PMA. The normalized Kerr signal shows a coercive field between 2 mT and 3 mT. For the measurement shown in Figure 6, the out-of-plane magnetic field was applied and swept between -10 mT and 10 mT. Presented results are based on measurements with two cycles (0 mT → 10 mT → -10 mT → 10 mT → -10 mT → 0 mT) on one spot. The Kerr signal is normalized between -1 and 1.

On the stack fabricated so far, the layer made using chiral molecules 2 is formed on the second Ta-layer 10. The layer made using chiral molecules 2 is a self-assembled monolayer of (R)-(⁻)-1,1'-binaphthyl-2,2'-diyl hydrogenphosphate (in the following short BNDHP). The two enantiomers of BNDHP are shown in Figure 5.

The BNDHP self-assembled monolayer is formed via immersion of the stack formed so far in a 10 mM solution of the BNDHP in either tetrahydrofuran or ethanol for at least 72 h. The sample is then annealed at 85°C for 1 h on a heating plate. Lastly, it is rinsed with isopropanol and again annealed at 85°C for 10 min. The inventors assume that the phosphoric acid terminal group of BDNHP anchors covalently to the native oxide of the second Ta-layer 10. Please note that for the present case the inventors think that the native oxide aids complementing the insulating properties of the organic molecules of the layer made using chiral molecules 2 in the present case. From this, the inventors conclude that anchoring a chiral self-assembled monolayer on a layer forming a native oxide may help to provide better insulation and thus to better avoid short circuiting, for example.

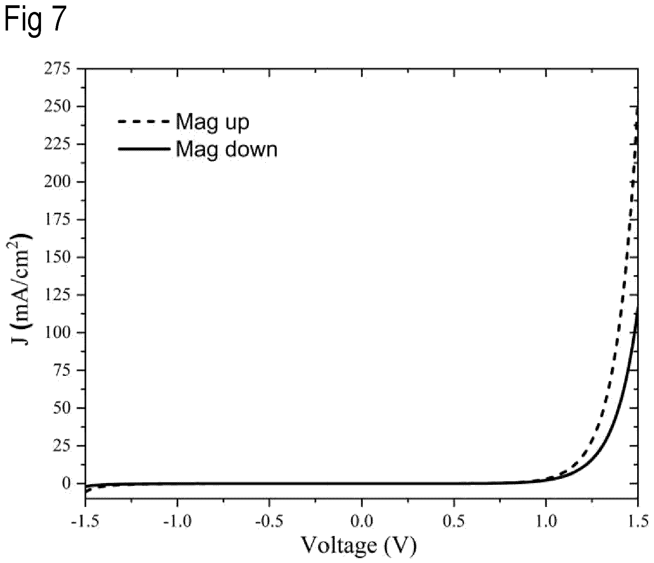

In order to prove that the switching device 1 does, in fact, exhibit two distinct resistance states, magnetic current-voltage characterizations were conducted using a temporary liquid metal top contact as the first contact 5 (eutectic gallium-indium; short EGaIn), the results of which are depicted in Figure 7. The EGaIn contact was fabricated according to R. Chiechi, E. Weiss, M. Dickey and G. Whitesides, "Eutectic Gallium-Indium (EGaIn): A Moldable Liquid Metal for Electrical Characterization of Self-Assembled Monolayers," Angewandte Chemie International Edition, 2008. Furthermore, a 190 mT permanent magnet was used to magnetize the information-storing free layer 4 in the two out-of-plane magnetization directions while recording the current-voltage curves with a source measure unit (Keithley 2635 System Source Meter). Please note that in Figure 7 the dashed line indicates the current density for measurements in which the external magnetic field was facing down and the solid line indicates the current density for when the magnetic field was directed upwards.

### Reference sign list

- 1: switching device
- 2: layer made using chiral molecules
- 2': second layer made using chiral molecules
- 3: isolating tunnel barrier
- 3': second insulating tunnel barrier
- 4: information-storing free layer
- 5: first contact
- 5': second contact
- 6: magnetic reference layer
- 7: bottom contact
- 8: substrate
- 9: first Ta-layer
- 10: second Ta-layer

## Claims

1. Switching device (1), comprising
a magnetic reference analogue portion comprising a layer made using chiral molecules (2).

2. Switching device (1) according to claim 1, wherein
the magnetic reference analogue portion comprises a magnetic reference layer (6) with pinned magnetic orientation, and the layer made using chiral molecules (2) neighbors the magnetic reference layer (6).

3. Switching device (1) according to claim 1 or 2, wherein the layer made using chiral molecules (2) is a chiral molecular layer.

4. Switching device (1) according to any of claims 1 to 3, wherein the entire reference analogue portion is a layer made using chiral molecules (2).

5. Switching device (1) according to claim 3 or 4, wherein the layer made using chiral molecules (2) has an enantiomeric excess.

6. Switching device (1) according to any of claims 3 to 5, wherein the layer made using chiral molecules (2) comprises chiral molecular units having an anchor group that chemically attaches the molecular unit to a surface.

7. Switching device (1) according to any of claims 3 to 6, wherein the layer made using chiral molecules (2) is a monolayer or sub-monolayer.

8. Switching device (1) according to any of claims 3 to 7, wherein the layer made using chiral molecules (2) is a self-assembled monolayer.

9. Switching device (1) according to any of claims 3 to 8, wherein the layer made using chiral molecules (2) comprises chiral molecular compounds or chiral polymers.

10. Switching device (1) according to claim 1 or 2, wherein the layer made using chiral molecules (2) is a chirally imprinted layer.

11. Switching device (1) according to the preceding claim, wherein the chirally imprinted layer comprises a chirally imprinted inorganic dielectric or chirally imprinted metal.

12. Switching device (1) according to claim 1 or 2, wherein the layer made using chiral molecules (2) comprises or consists of a chiral organic-inorganic material.

13. Switching device (1) according to the preceding claim, wherein the layer made using chiral molecules (2) is formed via atomic layer deposition including a chiral organic co-component.

14. Switching device (1) according to any of the preceding claims, further comprising an insulating tunnel barrier (3) and an information-storing free layer (4), which are arranged in a stack together with the magnetic reference analogue portion, wherein the insulating tunnel barrier (3) is arranged above a first side of the information-storing free layer (4) and between the magnetic reference analogue portion and the information-storing free layer (4).

15. Switching device (1) according to claim 14, wherein
a further insulating tunnel barrier (3') and a further magnetic reference analogue portion are arranged above a second side of the information-storing free layer (4), with the further insulating tunnel barrier (3') being arranged between the information-storing free layer (4) and the further magnetic reference analogue portion.

16. Switching device (1) according to claim 14 or 15, comprising means for applying a voltage and/or a current to the stack.

17. Switching device (1) according to any of claims 14 to 16, wherein the information-storing free layer (4) comprises or consists of a material exhibiting perpendicular magnetic anisotropy.

18. Switching device (1) according to any of claims 14 to 16, wherein the information-storing free layer (4) comprises or consists of a ferromagnetic material, such as an Fe-based material, and FeCo-based material, an Ni-containing material, a Dy-containing material, a Ho-containing material, a CoFeB-based material, a Co-based material, or
has insertion layers, such as insertion layers comprising or consisting of Mo

19. Switching device (1) according to any of the preceding claims, being a magnetoresistive random access memory device, a device for neuromorphic computing, a device for reading a hard disc drive, a magnetic field sensor, or a device for quantum computing.

20. Process of forming a switching device (1), including the steps of
forming an information-storing free layer (4),
forming a layer made using chiral molecules (2) above the information-storing free layer (4).

21. Process of forming a switching device (1), wherein the layer made using chiral molecules (2) is formed via immersion in solution, Langmuir-Blodgett technique, molecular layer deposition, spin coating, or a sol-gel process.
